Europäisches Patentamt

European Patent Office

Office européen des brevets

(11) Veröffentlichungsnummer: **0 370 276 B1**

(19)

(12) ## EUROPÄISCHE PATENTSCHRIFT

(45) Veröffentlichungstag der Patentschrift: **19.01.94**

(21) Anmeldenummer: **89120221.0**

(22) Anmeldetag: **31.10.89**

(51) Int. Cl.⁵: **H01J 37/244**

(54) **Vorrichtung zum Nachweis geladener Sekundärteilchen.**

(30) Priorität: **21.11.88 DE 3839316**

(43) Veröffentlichungstag der Anmeldung:
**30.05.90 Patentblatt 90/22**

(45) Bekanntmachung des Hinweises auf die
Patenterteilung:
**19.01.94 Patentblatt 94/03**

(84) Benannte Vertragsstaaten:
**DE FR GB NL**

(56) Entgegenhaltungen:
**EP-A- 0 259 907**
**US-A- 4 658 137**

(73) Patentinhaber: **SIEMENS AKTIENGESELL-
SCHAFT**
**Wittelsbacherplatz 2**
**D-80333 München(DE)**

(72) Erfinder: **Brunner, Matthias, Dr.-Ing.**
**Graf-Andechs-Strasse 30**
**D-8011 Kirchheim(DE)**
Erfinder: **Schmid, Ralf, Dipl.-Phys.**
**Mozartstrasse 5**
**D-8000 München 2(DE)**
Erfinder: **Regula, Michael, Dipl.-Phys.**
**Leopoldstrasse 96**
**D-8000 München 40(DE)**

**Beschreibung**

Die Erfindung bezieht sich auf eine Vorrichtung zum Nachweis geladener Sekundärteilchen nach dem Oberbegriff des Patentanspruchs 1.

Eine solche Vorrichtung ist aus der DE-A-35 90 146 bekannt.

Trifft ein Teilchenstrahl auf eine Probe, so werden aufgrund der Wechselwirkung der Primärteilchen mit dem Festkörper Sekundärteilchen emittiert, deren Energie- und Winkelverteilung unter anderem von der im Wechselwirkungsbereich vorliegenden chemisch-physikalischen Zusammensetzung, der Oberflächenstruktur und der auf der Probe vorhandenen Potentialverteilung abhängt. Von besonderer Bedeutung für die Bilderzeugung und die Potentialmessung in Rasterelektronenmikroskopen sind die in oberflächennahen Schichten ausgelösten Sekundärelektronen, die man üblicherweise in einem seitlich oberhalb der Probe angeordneten Detektor nachweist. Dieser erzeugt allerdings ein stark unsymmetrisches Absaugfeld, so daß quantitative Potentialmessungen nur innerhalb eines sehr kleinen Abtastfeldes durchgeführt werden können.

Um einen vom Auslösepunkt und Emissionswinkel unabhängigen Nachweis der Sekundärelektronen zu gewährleisten, werden mehrere symmetrisch zur Primärstrahlachse angeordnete Detektoren verwendet. Diese beispielsweise aus der JP-A-58 35 854 bekannten Mehrdetektorsysteme besitzen allerdings den Nachteil, daß dem Sekundärelektronensignal aufgrund der gegenüber Einzeldetektoren vervielfachten Detektorfläche ein durch Rückstreuelektronen erzeugtes Störsignal überlagert ist. Auch in diesen Detektorsystemen ist das für quantitative Messungen nutzbare Abtastfeld auf wenige mm$^2$ beschränkt.

Der Erfindung liegt die Aufgabe zugrunde, eine Vorrichtung der Eingangs genannten Art anzugeben, in der die Nachweiswahrscheinlichkeit für die auf einer Probe ausgelösten Sekundärteilchen unabhängig ist vom Ort der Meßstelle innerhalb eines großflächigen Abtastfeldes. Die Vorrichtung soll insbesondere für das Elektronenstrahltesten von Leiterplatten geeignet sein. Diese Aufgabe wird erfindungsgemäß durch eine Vorrichtung nach Patentanspruch 1 gelöst.

Der mit der Erfindung erzielbare Vorteil besteht insbesondere darin, daß dem erzeugten Potential-, Topographie- oder Materialkontrastsignal keine durch die Detektorgeometrie bedingten ortsabhängigen Störungen überlagert sind. Außerdem werden die Signalbeiträge rückgestreuter Primärelektronen erheblich reduziert.

Die abhängigen Ansprüche betreffen bevorzugte Ausgestaltungen und Weiterbildungen der Erfindung, die im folgenden anhand der Zeichnung näher erläutert wird. Hierbei zeigt

| | |
|---|---|
| Figur 1 | den schematischen Aufbau einer erfindungsgemäßen Vorrichtung zum Nachweis von Sekundärelektronen |
| Figur 2 | einen elektrostatischen Oktupol zur Ablenkung der Sekundärelektronen |
| Figur 3 | die Potentialverteilung innerhalb der Vorrichtung nach Fig. 1 |
| Figur 4 und 5 | berechnete Sekundärelektronenbahnen innerhalb der erfindungsgemäßen Vorrichtung |
| Fig. 6 | einen magnetischen Oktupol zur Ablenkung der Sekundärelektronen |

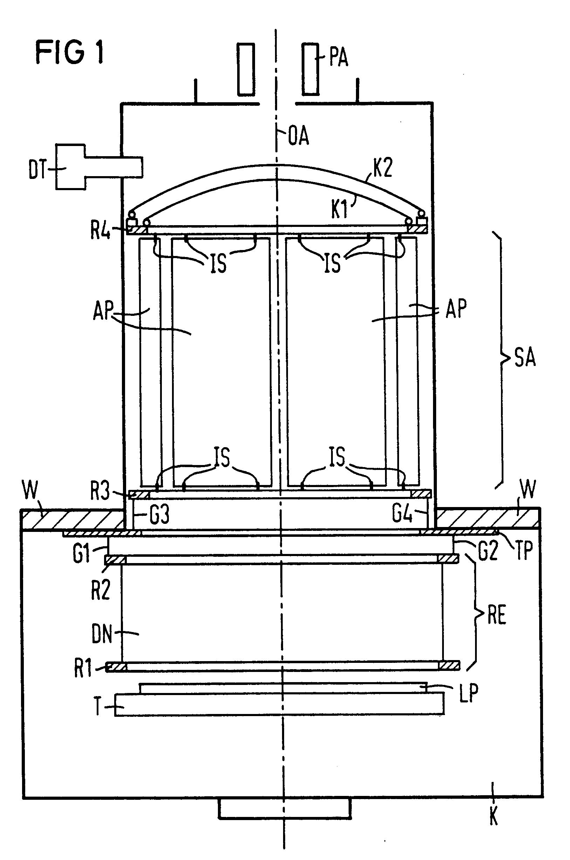

Die in Fig. 1 schematisch dargestellte Vorrichtung zum Nachweis von Sekundärelektronen kann insbesondere in Elektronstrahlmeßgeräten zum Testen von Leiterplatten und Verdrahtungsmodulen verwendet werden. Sie ersetzt das konventionelle Detektorsystem und wird oberhalb der zu untersuchenden Leiterplatte LP in einer evakuierten Kammer K auf einem bezüglich der Primärstrahlachse OA ausrichtbaren Tisch T angeordnet. Den Elektronenstrahl zur Aufladung der Leitungsnetzwerke und zur Abtastung der sich entsprechend der Netzwerkgeometrie ausbildenden Potentialverteilung erzeugt man üblicherweise in einem modifizierten Rasterelektronenmikroskop, dessen Säule einen Strahlerzeuger, eine oder mehrere Kondensorlinsen, eine Objektivlinse und ein Ablenksystem PA zur Positionlerung des primären Elektronenstrahls innerhalb des bis zu 20 x 20 cm$^2$ großen Abtastfeldes aufweist. Die an der jeweiligen Meßstelle ausgelösten Sekundärelektronen werden in einem bezüglich der Primärstrahlachse OA rotationssymmetrischen elektrischen Feld in Richtung der oberhalb einer Rohrelektrode RE angeordneten Ablenkeinheit SA beschleunigt, in einem zwischen zwei annähernd halbkugelförmigen Elektroden K1 und K2 aufgebauten elektrischen Gegenfeld abgebremst und in Richtung des aus einem auf einem hohen positiven Potential von etwa 10 kV liegenden Szintillator, einem Lichtleiter und einem Photomultiplier bestehenden Detektor DT abgesaugt.

Die unmittelbar oberhalb der Leiterplatte LP symmetrisch zur Primärstrahlachse OA angeordnete Rohrelektrode RE besitzt vorzugsweise einen kreisförmigen Querschnitt, wobei der Rohrdurchmesser etwas größer gewählt ist als die Leiterplattendiagonale. Diese auf Masse bzw. einem niedrigen negativen Potential $U_{RE}$ von beispielsweise $U_{RE}$ = -5 V bis -50 V liegende Rohrelektrode RE besteht aus zwei durch mehrere Gewindestangen verbunden Aluminium-Trägerringen R1, R2 und einem in Führungsschienen gehaltenen Edelstahldrahtnetz DN (Drahtdurchmesser d ≈ 0,25 mm, Maschenweite w ≈ 1 mm). Zur Befestigung der Rohrelektrode RE und der Ablenkeinheit SA an der mit der Kammerwand W verschraubten Aluminiumplatte TP finden Gewindestangen G1 bis G4 Verwendung, die jeweils durch Buchsen und Unterlegscheiben aus vernetztem Polystyrol isoliert mit den Trägerring R2 bzw. R3 verbunden sind.

Als Ablenkeinheit SA dient ein symmetrisch zur Primärstrahlachse OA angeordneter elektrischer Oktupol, dessen aus zwei Aluminiumringen R3 und R4 bestehender Rahmen ebenso wie die Aluminumplatte TP auf dem Absaugpotential $U_A$ von beispielsweise $U_A$ = 1 bis 3 kV liegen. An der Schmalseite jeder der Ablenkplatten AP des Oktupols sind Streifen IS aus vernetzten Polystyrol angebracht, die passend in ein in den Trägerringen R3 und R4 jeweils vorhandenen Führungsnut eingreifen. Zur Erhöhung der mechanischen Stabilität sind die Trägerringe R3 und R4 wiederum über Gewindestangen miteinander verbunden.

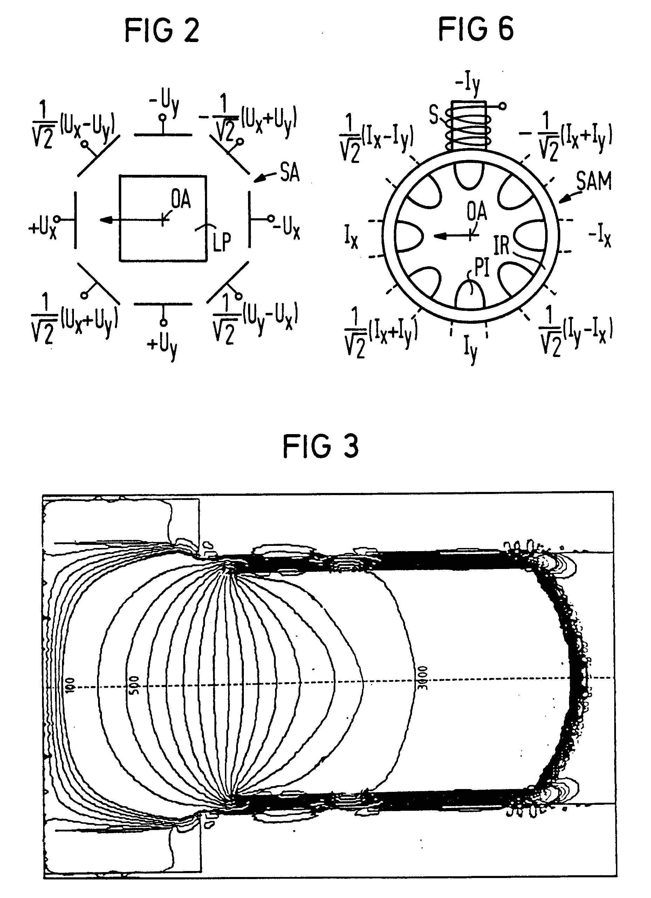

Um die im rotationssymmetrischen elektrischen Absaugfeld erzeugten Sekundärelektronenbündel in Richtung des seitlich oberhalb des Oktupols SA angeordneten Detektors DT abzulenken, werden die vorzugsweise aus einem Drahtnetz bestehenden Ablenkplatten AP mit den in Fig. 2 angegebenen Potentialen beaufschlagt. Den Ablenkpotentialen $U_x$ beziehungsweise $U_y$ ist hierbei jeweils noch das positive Absaugpotential $U_A$ überlagert.

Nach ihrer Ablenkung im Feld des elektrostatischen Oktupols SA (in Fig. 2 ist die Ablenkrichtung durch einen Pfeil gekennzeichnet) durchlaufen die Sekundärelektronen ein zwischen zwei annähernd halbkugelförmigen Elektroden K1 und K2 aufgebautes elektrisches Gegenfeld. Diese auf dem oberen Trägerring R4 angeordneten Elektroden K1 und K2 bestehen jeweils aus einem hartgelöteten Drahtring und einem Drahtgewebe, das eine Maschenweite von etwa 1,6 mm und eine Drahtstärke von etwa 0,22 mm aufweist. Während die leitend mit dem Trägerring R4 verbundene Elektrode K1 auf dem Absaugpotential $U_A$ liegt, wird die Netzelektrode K2 mit einem Potential $U_G$ von etwa $U_G$ = -15 Volt bis +15 Volt beaufschlagt, so daß nur Sekundärelektronen mit Energien oberhalb eines durch das Potential $U_G$ vorgebbaren Schwellenwertes den Detektor DT erreichen (Verbesserung des Potentialkontrastsignals).

Fig. 3 zeigt die berechnete Feldverteilung innerhalb der erfindungsgemäßen Vorrichtung. Hierbei wurde angenommen, daß die Rohrelektrode RE und die Ablenkeinheit SA auf einem Potential von $U_{RE}$ = -18 Volt bzw. $U_A$ = 3 kV liegen ($U_x$ = $U_y$ = $U_G$ = 0 Volt). Man erkennt deutlich die Homogenität des Absaugfeldes unmittelbar oberhalb der zu untersuchenden Probe.

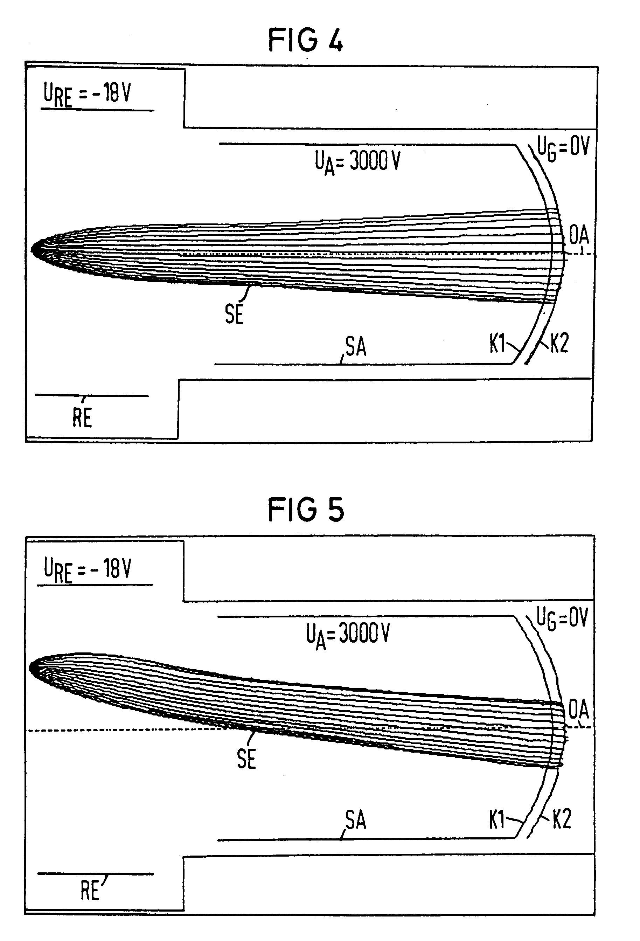

Die bündelnde Wirkung des bezüglich der Primärstrahlachse OA rotationssymmetrischen Absaugfeldes wird anhand der Fig. 4 und 5 verdeutlicht. Dargestellt sind jeweils die berechneten Trajektorien für den Fall, daß die Sekundärelektronen SE in der Leiterplattenmitte bzw. auf der Diagonale etwa 10 cm außerhalb der Mitte mit einer Energie von 20 eV unter einem Winkel von 40° bis 180° bezüglich der Leiterplattenebene starten. Unabhängig vom Auslöseort treten die Sekundärelektronen SE nahezu senkrecht in das zwischen den Elektroden K1 und K2 aufgebaute Gegenfeld. Außerdem ist zu erkennen, daß auch die annähernd senkrecht zur Primärstrahlachse OA emittierten Sekundärelektronen SE erfaßt und in Richtung der Ablenkeinheit SA beschleunigt werden.

Die Erfindung ist selbstverständlich nicht auf die beschriebenen Ausführungsbeispiele beschränkt. So ist es ohne weiteres möglich, einen magnetischen Oktupol SAM zur Ablenkung der Sekundärelektronen zu verwenden. Wie die Fig. 6 zeigt, besteht dieser Oktupol SAM aus 8 auf dem Potential $U_A$ liegenden inneren Polschuhen PI, die durch einen Isolatorring IR von den auf Masse bzw. Erdpotential liegenden und mit jeweils einer Erregerwicklung S versehenen äußeren Polschuhen getrennt sind. Zur Ablenkung der Sekundärelektronen in der durch den Pfeil angegebenen Richtung müssen die jeweils angegebenen Ströme in den Erregerwicklungen S fließen.

Die beschriebene Vorrichtung kann selbstverständlich auch zum Nachweis von Ionen oder Photoelektronen verwendet werden, falls man die zu untersuchende Probe mit einem Ionen- oder Laserstahl abtastet.

Die Querschnittsfläche der Rohrelektrode RE kann eine beliebige Form aufweisen. Der Rohrdurchmesser muß dann allerdings so gewählt werden, daß das elektrische Feld innerhalb des Abtastfeldes weiterhin Rotationssymmetrie bezüglich der Primärstrahlachse OA aufweist.

## Patentansprüche

1. Vorrichtung zum Nachweis geladener Sekundärteilchen mit einem Detektor (DT) und einer Ablenkeinheit (SA) zur Ablenkung der von einem Primärstrahl auf einer Probe (LP) ausgelösten Sekundärteilchen (SE) **gekennzeichnet durch** eine in Primärstrahlrichtung unterhalb der Ablenkeinheit (SA) angeordnete, auf einem ersten Potential ($U_{RE}$) liegende Rohrelektrode (RE), deren Längsachse parallel zur Symmetrieachse (OA) der Ablenkeinheit (SA) orientiert ist.

2. Vorrichtung nach Anspruch 1, **gekennzeichnet durch** ein elektrostatisches oder magnetisches Multipolelement (R3, R4, AP) als Ablenkeinheit (SA).

3. Vorrichtung nach Anspruch 2, **gekennzeichnet durch** ein elektrostatisches oder magnetisches Oktupolelement (R3, R4, AP) als Ablenkeinheit (SA).

4. Vorrichtung nach einem der Ansprüche 1 bis 3, **dadurch gekennzeichnet,** daß die Ablenkeinheit (SA) ein jeweils auf einem positiven zweiten Potential ($U_A$) liegendes oberes und unteres Trägerelement (R3, R4) aufweist und daß eine mit dem zweiten Potential ($U_A$) beaufschlagte zweite Elektrode (K1) auf dem oberen Trägerelement (R4) angeordnet ist.

5. Vorrichtung nach Anspruch 4, **dadurch gekennzeichnet,** daß oberhalb der zweiten Elektrode (K1) eine dritte Elektrode (K2) angeordnet ist und daß die dritte Elektrode (K2) mit einem dritten Potential ($U_G$) derart beaufschlagt ist, daß sich im Raumbereich zwischen der zweiten und der dritten Elektrode (K1, K2) ein die Sekundärteilchen (SE) abbremsendes elektrisches Feld aufbaut.

6. Vorrichtung nach Anspruch 5, **dadurch gekennzeichnet,** daß die zweite und die dritte Elektrode (K1, K2) annähernd kugelsymmetrische Gestalt besitzen.

7. Vorrichtung nach einem der Ansprüche 2 bis 6, **dadurch gekennzeichnet,** daß die Elektroden (AP) des elektrostatischen Multipolelements (SA) auf dem zweiten Potential ($U_A$) liegen und daß dem zweiten Potential ($U_A$) jeweils ein Ablenkpotential ($U_x$, $U_y$) überlagert ist.

8. Vorrichtung nach einem der Ansprüche 2 bis 6, **dadurch gekennzeichnet,** daß die inneren Pole (PI) des magnetischen Multipolelements (SAM) auf dem zweiten Potential ($U_A$) liegen.

## Claims

1. Device for detecting charged secondary particles, having a detector (DT) and a deflecting unit (SA) for deflecting the secondary particles (SE) released by a primary beam on a specimen (LP), characterized by a tube electrode (RE), which is disposed in the direction of the primary beam below the deflecting unit (SA) and which is at a first potential ($U_{RE}$) and the longitudinal axis of which is oriented parallel to the axis of symmetry (OA) of the deflecting unit (SA).

2. Device according to Claim 1, characterized by an electrostatic or magnetic multipole element (R3, R4, AP) as deflecting unit (SA).

3. Device according to Claim 2, characterized by an electrostatic or magnetic eight pole element (R3, R4, AP) as deflecting unit (SA).

4. Device according to one of Claims 1 to 3, characterized in that the deflecting unit (SA) exhibits an upper and lower carrier element (R3, R4) which are respectively at a positive second potential ($U_A$), and in that a second electrode (K1) acted upon by the second potential ($U_A$) is disposed on the upper carrier element (R4).

5. Device according to Claim 4, characterized in that above the second electrode (K1) there is disposed a third electrode (K2), and in that the third electrode (K2) is acted upon by a third potential ($U_G$) in such a manner that an electric field decelerating the secondary particles (SE) is built up in the spatial region between the second and the third electrode (K1, K2).

6. Device according to Claim 5, characterized in that the second and the third electrode (K1, K2) have an approximately spherically symmetric design.

7. Device according to one of Claims 2 to 6, characterized in that the electrodes (AP) of the electrostatic multipole element (SA) are at the second potential ($U_A$),and in that in each instance a deflecting potential ($U_x$, $U_y$) is superposed upon the second potential ($U_A$).

8. Device according to one of Claims 2 to 6, characterized in that the inner poles (PI) of the magnetic multipole element (SAM) are at the second potential ($U_A$).

## Revendications

1. Dispositif pour détecter des particules secondaires chargées, comportant un détecteur (DT) et une unité de déviation (SA) servant à faire dévier les particules secondaires (SE) déclenchées par un faisceau primaire sur un échantillon (LP), caractérisé par une électrode tubulaire (RE), qui est disposée dans la direction du faisceau primaire en-dessous de l'unité de déviation (SA), qui est placée à un premier potentiel ($U_{RE}$) et dont l'axe longitudinal est orienté parallèlement à l'axe de symétrie (OA) de l'unité de déviation (SA).

**2.** Dispositif suivant la revendication 1, caractérisé par un élément multipolaire (R3, R4, AP) électrostatique ou magnétique en tant qu'unité de déviation (SA).

**3.** Dispositif suivant la revendication 2, caractérisé par un élément octopolaire (R3, R4,AP) électrostatique ou magnétique tant qu'unité de déviation (SA).

**4.** Dispositif suivant l'une des revendications 1 à 3, caractérisé par le fait que l'unité de déviation (SA) comporte un élément de support supérieur et un élément de support inférieur (R3, R4), placés respectivement à un deuxième potentiel positif ($U_A$), et qu'une deuxième électrode (K1) chargée par le deuxième potentiel ($U_A$) est disposée sur l'élément de support supérieur (R4).

**5.** Dispositif suivant la revendication 4, caractérisé par le fait qu'une troisième électrode (K2) est disposée au-dessus de la deuxième électrode (K1) et que la troisième électrode (K2) est chargée par un troisième potentiel ($U_G$) de telle sorte qu'un champ électrique, qui freine les particules secondaires (SE), s'établit dans la zone d'espace comprise entre les deuxième et troisième électrodes (K1,K2).

**6.** Dispositif suivant la revendication 5, caractérisé par le fait que les deuxième et troisième électrodes (K1,K2) ont une configuration approximativement à une symétrie sphérique.

**7.** Dispositif suivant l'une des revendications 2 à 6, caractérisé par le fait que les électrodes (AP) de l'élément multipolaire (SA) électrostatique sont placées au deuxième potentiel ($U_A$) et qu'un potentiel de déviation ($U_x$, $U_y$) est superposé au deuxième potentiel ($U_A$).

**8.** Dispositif suivant l'une des revendications 2 à 6, caractérisé par le fait que les pôles intérieurs (PI) de l'élément multipolaire (SAM) magnétique sont placés au deuxième potentiel ($U_A$).

FIG 1

## FIG 2

$$\frac{1}{\sqrt{2}}(U_x - U_y) \qquad -U_y \qquad -\frac{1}{\sqrt{2}}(U_x + U_y)$$

SA

OA

$+U_x$     $-U_x$

LP

$$\frac{1}{\sqrt{2}}(U_x + U_y) \qquad +U_y \qquad \frac{1}{\sqrt{2}}(U_y - U_x)$$

## FIG 6

$-I_y$

S

$$\frac{1}{\sqrt{2}}(I_x - I_y) \qquad \qquad -\frac{1}{\sqrt{2}}(I_x + I_y)$$

SAM

$I_x$    OA    $-I_x$

IR

PI

$$\frac{1}{\sqrt{2}}(I_x + I_y) \qquad I_y \qquad \frac{1}{\sqrt{2}}(I_y - I_x)$$

## FIG 3

## FIG 4

$U_{RE} = -18\,V$

$U_A = 3000\,V$

$U_G = 0V$

OA

SE

SA

K1  K2

RE

## FIG 5

$U_{RE} = -18\,V$

$U_A = 3000\,V$

$U_G = 0V$

OA

SE

SA

K1  K2

RE′